Europäisches Patentamt

European Patent Office

Office européen des brevets

(19)

(11) Publication number: **0 132 323**
**A2**

# (12) EUROPEAN PATENT APPLICATION

(21) Application number: **84304409.0**

(22) Date of filing: **28.06.84**

(51) Int. Cl.⁴: **H 01 L 29/24, H 01 L 21/203**

(30) Priority: **29.06.83 US 509175**

(43) Date of publication of application: **30.01.85**
**Bulletin 85/5**

(84) Designated Contracting States: **AT BE CH DE FR GB IT LI LU NL SE**

(71) Applicant: **STAUFFER CHEMICAL COMPANY, Westport Connecticut 06881 (US)**

(72) Inventor: **Bunz, Louis Andrew, 24 Croton Park Road, Peekskill, N.Y. 10566 (US)**
Inventor: **Schachter, Rozalie, 75-14 173rd Street, Flushing, N.Y. 11366 (US)**
Inventor: **Viscogliosi, Marcello, 176 North Washington Street, North Tarrytown, N.Y. 10591 (US)**

(74) Representative: **Smith, Sydney et al, Elkington and Fife High Holborn House 52/54 High Holborn, London WC1V 6SH (GB)**

(54) **Sputtered semiconducting films of catenated phosphorus material and devices formed therefrom.**

(57) A process for the production of a semiconducting catenated phosphorus film characterised in that it comprises sputtering a thin film thereof onto a substrate is disclosed.

The present process may be applied to the production of semiconductor devices. Referring to the accompanying illustrative drawing, a sputtered film 22 may be used in a sandwich configuration on a glass substrate 24 with a metallic lock contact 26 and metal dot top contacts 28.

For example, amorphous and polycrystalline films of $KP_{15}$ may be formed by RF diode sputtering targets of $KP_{15}$ and excess phosphorus in an argon phase. Substrate temperatures up to 280–300°C provide amorphous films. Higher temperatures provide microcrystalline or polycristalline films. These films have high resistance and may be used as the insulator in MIS devices employing III–V semiconductors. Co-sputtering with nickel increases the conductivity of the films from approximately $10^{-10}$ (ohm–cm)$^{-1}$ to $10^{-2}$ (ohm–cm)$^{-1}$; only reduces the optical gap by 0.2 eV; and reduces the activation energy from 0.8 eV to 0.2 eV; the nickel content varying from 5–15%. Substrates include glass, silicon, tantalum, stainless steel, gallium phosphide and gallium arsenide, and glass metallized with metals, such as titanium, nickel and aluminium. Double diode electrical characteristics have been observed in devices formed on metallized glass substrates having co-sputtered thereon thin film polyphosphides and nickel with nickel and titanium top contacts.

The present invention represents an advance over the prior art.

-1-

Sputtered semiconducting films of catenated phosphorus
material and devices formed therefrom

This invention relates to sputtered semiconducting films of catenated phosphorus material and to devices formed therefrom; more particularly, it relates to such films, to the modification of the resistivity thereof by the incorporation of co-sputtered metals and to the production of electronic semiconductor devices, electro-optical devices, thin films, optical films and coatings.

For further information, reference may be made to for example, GB-A- 2,113,663 and to the related applications filed herewith, in particular, those based on USSN 509,158, USSN 581,115, USSN 581,139 and USSN 509,157.

The above-identified co-pending applications disclose semiconductors formed of catenated phosphorus materials. It is highly desirable that uniform thin films of these materials be formed on a variety of substrates for use in electronic and electro-optical devices, such as optical films and coatings. It is further highly desirable that an easy and convenient method be found to reduce the intrinsic resistivity of these materials and the conductivity activation energy thereof.

It is therefore an object of the present invention to provide sputtered films of catenated phosphorus materials.

Another object of the present invention is to provide insulating films on III-V materials.

Still another object of the present invention is to increase the conductivity and decrease the conductivity activation energy of semiconducting films of catenated phosphorus materials without significantly reducing the optical band gap.

A further object of the present invention is to provide such films on a variety of substrates.

Yet another object of the present invention is to provide semiconductor and electro-optical devices, optical films and coatings.

In general terms, the present invention relates to catenated phosphorus semiconducting films which may be formed on substrates by sputtering, in particular in the form of active films in semiconductor devices.

The present invention provides a process for the production of a semiconducting catenated phosphorus film characterised in that it comprises sputtering a thin film thereof onto a substrate.

Preferably, the film comprises $MP_x$, wherein x is equal to or greater than 15, more preferably substantially equal to 15; and M represents an alkali metal, more preferably potassium. The substrate may be glass, optionally metallised with, for example, tantalum, nickel, titanium or aluminium, silicon tantalum, stainless steel or a III-V semiconductor, such as gallium phosphide, gallium arsenide or indium phosphide. The sputtering is generally RF sputtering in an argon atmosphere.

If desired, a metal, for example one having unfilled d or f orbitals, such as nickel, say from 5 to 15%, may be incorporated by co-sputtering.

In one embodiment, the present process may comprise:

(A) providing a target of $MP_{15}$; and

(B) providing a source of additional phosphorus.

The additional source may be provided by incorporating elemental phosphorus at the target of $MP_{15}$ and/or by providing pieces of $MP_x$, wherein x is very much greater than 15, at the target of $MP_{15}$ and/or by providing phosphine gas during sputtering.

In another embodiment, the present process may comprise:

(A) providing a target comprising phosphorus, an alkali metal and a metal dopant; and

(B) sputtering a film of $MP_x$ and the metal dopant onto a substrate from the target.

The use of a non-alkali metal dopant may reduce the intrinsic resistance of the present semiconducting films.

The example, diodes may be provided in accordance with the present invention.

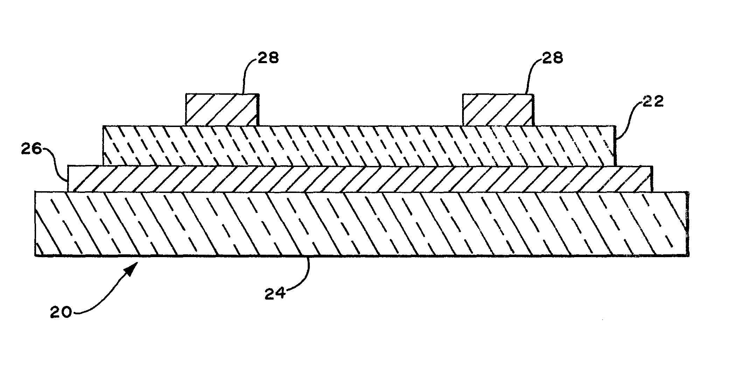

For a fuller understanding of the present invention, reference may be made to the following detailed description taken in connection with the accompanying drawing which is an illustrative schematic diagram of a semiconductor device according to the present invention.

High quality thin films of polyphosphides, namely $KP_x$, wherein x is equal to or greater than 15, have now been produced by sputtering. Such high quality thin films covering a surface area of more than 100 square centimetres have now been provided. Highly insulating films have now been successfully deposited on III-V materials. In addition, the conductivity of these films has now been increased by co-sputtering with nickel. The thus-produced thin films may be used in semiconductor devices, for coatings, for optical films and in electro-optical devices, for example.

Using RF diode sputtering with an argon plasma at a pressure of approximately 10 millitorr (1.33 pa) and power of 100 watts, glass substrates located 5 cm from the target and the substrate temperatures from 25 to 300°C, film thicknesses up to 4 μm (microns) have been produced on glass substrates. Gallium phosphide, gallium arsenide, silicon, tantalum and stainless steel substrates, as well as metallized glass substrates, metallized with titanium, nickel and aluminium, for example, have been successfully coated. It is believed that many other substrates including indium phosphide may also be coated. Based on X-ray data, films grown on a substrate at a temperature of greater than 300°C are polycrystalline or microcrystalline. When the substrate temperature is below 280°C, amorphous films are produced. Both may be utilized in semiconductor devices, electro-optical devices and coatings, for example, as discussed in detail in the above-identified co-pending applications.

The presently-preferred target comprises $KP_{15}$ formed by a condensed phase process as described in detail in the above identified co-pending applications, pressed under 30,000 pounds per square inch (2109 kg/sq.cm / $2.07 \times 10^7$ Pa) pressure, into a 2 inch (5cm diameter, 1/4 inch (0.6 cm) thick disc. Pieces of $KP_x$, wherein x is much greater than 15, 1/4 inch (0.6 cm) thick, sliced from a boule grown in a single source process as described in the above-identified co-pending applications, are glued to the condensed phase $KP_{15}$ disc, which then has from 20 to 70%, by weight, excess phosphorus over that of pure $KP_{15}$. The $KP_x$ slices wherein x is much greater than 15 cover from 30 to 50% of the area of the target and the discs of nickel cover from 5 to 10%. There have been obtained shiny stable films of from 0.5 to 2.5 μm (microns) in thickness under the following conditions; RF diode mode, argon pressure of 10 millitorr (1.33 Pa), substrate temperature approximately 280-300°C, power 200 watts, target voltage 2,400 volts, and a deposition sputtering time of 1.5 hours.

The films contain from 5 to 15% nickel; all show increased conductivity; some as high as $10^{-4}$ (ohm-cm)$^{-1}$ compared with approximately $10^{-10}$ (ohm-cm) in films where no nickel is present.

It has been demonstrated that the conductivity modification was of a true semiconductor and not a metallic alloy type by measuring the conductivity activation energy of the films _in vacuo_. The activation energy was reduced from 0.8 eV in intrinsic materials (i.e. no nickel present) to 0.2 eV and the optical gap was reduced by only 0.2 eV. Thus, it is believed that nickel acts as a dopant.

Films including nickel deposited on a previously metallized glass substrate and then having nickel or titanium top contacts applied thereto by vacuum evaporation, show a double diode characteristic at both interfaces between the metals and the nickel-containing material. Significant current of the order of milliamps may be drawn through the devices.

It is believed that similar films of $MP_x$, wherein M represents an alkali metal and x is equal to or greater than 15, may be formed by the same process and may have the properties thereof changed in the same manner by co-sputtering with nickel.

Alternatively, the excess phosphorus supplied by the $KP_x$ pieces, wherein x is much greater than 15, may be supplied by other means. For example, there have been used mixtures of condensed phase $KP_{15}$ and red phosphorus powders for the target disc as well as mixtures of $KP_{15}$ and crystalline phosphorus formed as a condensed phase charge from a ball-milled mixture. It is believed that the excess phosphorus may be supplied by sputtering a pure $KP_{15}$ target and depositing on a substrate in the presence of phosphine ($PH_3$) gas.

It is also believed that other metals having unfilled d or f orbitals co-sputtered with these semi-conducting catenated phosphorus materials ($MP_x$ wherein M represents an alkali metal and x ranges from 15 to infinity) will similarly alter the intrinsic properties thereof and thus increase the conductivity and upin the Fermi level, i.e. act as dopant.

For the purposes of illustration:

RF diode sputtering was performed in a Materials Research Corporation Model 86-20 sputterer with a variety of targets and substrates. Argon was used for the plasma. The substrates were located approximately 5 centimetres from a water-cooled target. The substrate's temperature was controlled. Good quality $KP_{15}$ films of from 0.2 to 4.0 μm (microns) thickness were produced on a variety of substrates.

Due to high volatility of phosphours, pure $KP_{15}$ targets cannot be used as they will only produce films high in potassium. It has been discovered that, in order to produce $KP_{15}$ films, excess phosphorus must be provided. The presently-preferred source of excess phosphorus is $KP_x$, wherein x is much greater than 15, grown by the single source vapour transport process of the above-identified, previously filed, applications. Other sources which have been employed include bulk red phosphorus and crystalline phosphorus formed in the condensed phase process of the above-identified, previously filed, applications. It is believed that phosphine gas could also be used.

Although RF diode sputtering has been used, it is believed that other sputtering modes, such as direct current and magnetron, will also be successful.

Example 1

In one example, a target composed of a mixture of condensed phase $KP_{15}$ plus 60% red phosphorus was prepared by pressing at 30,000 psi (2109 kg/sq cm / $2.07 \times 10^7$ Pa) into a 2" (5cm) diameter disc. The sputtering parameters were the following:

Argon pressure = 10 millitorr (1.33 pa), RF power = 140 watts, target voltage = 2,400 V, substrate temperature = 300°C, deposition time = 7 hours. In this run, the deposited films were approximately 3 μm (microns) thick. Some of the films deposited on a glass substrate, were analyzed for chemical composition by X-ray fluorescence and had $KP_{15}$ composition. Raman structure and X-ray diffraction pattern identified a crystalline $KP_{15}$ film. The electro-optical properties were measured: the conductivity was approximately $10^{-10}$ $(\text{ohm-cm})^{-1}$; the activation energy of conductivity was 0.7 eV; the optical gap was 1.7 eV; photoluminescence was observed at 1.75 eV. The photoconductivity ratio under one sun illumination was approximately $10^{+2}$.

Example 2

In this example, the target was prepared from condensed phase $KP_{15}$ with pellets of bulk $KP_x$, wherein x is very much greater that 15, from single source vapour transport covering approximately 50% of the target area and Ni discs covering approximately 10% of the target area.

The sputtering parameters were: Argon pressure = 10 millitorr (1.33 Pa); RF power approximately 150 Watts; target voltage = 2,400 Volts; time = 1.5 hours; substrate temperature = 280°C.

These films were analyzed for Ni content and composition. Depending on the position of the substrate relative to the intensity of the plasma, there were obtained amorphous films of $KP_{15}$ composition closer to the centre of the plasma and $KP_{20}$ 5 centimetres away from the centre of the plasma. The Ni content in the above two films is 15% and 8%, respectively. These films have been deposited on glass, metallized glass (Ni and Ti), polished single crystal Si, polished GaP, stainless steel and Ta films.

The electro-optical properties of such films were measured. A film having 8% Ni concentration has a resistivity dropped from $10^{10}$ (ohm-cm) to $10^4$ (ohm-cm) and conductivity activation energy reduced to 0.3 eV from 0.8 eV. On the other hand, the optical gap, measured by transmission edge only, dropped from 1.7 to 1.5 eV, indicating that the material consists of amorphous poly-phosphide matrix with Ni contributing to reduction in resistivity and unpinning the Fermi level.

Referring to the accompanying Figure, electronic devices generally indicated at 20, prepared on such a material 22 in a sandwich configuration on a glass substrate 24 with a metallic back contact 26 of Ni, Ti or Ta and metal dot top contacts 28 of Ni or Ti, show current-voltage and capacitance-voltage characteristics of two reverse biased diodes. The non-linearity in the I-V is strong, with current capability in the milliamp range on devices having an area of $10^{-3}$ $(cm)^2$.

Example 3

This example was similar in parameters to Example 2, except the Ni concentration on the target is approximately 6% and the excess phosphorus was provided from pieces of commercial amorphous red phosphorus placed onto the target. The Ni concentration in the resulting films is approximately 6%, the resistivity was reduced to $10^6$ (ohm-cm) and the activation energy is 0.5 eV.

Device characteristics were similar to Example 2.

CLAIMS:

1. A process for the production of a semiconducting catenated phosphorus film characterised in that it comprises sputtering a thin film thereof onto a substrate.

2. A process as claimed in claim 1 wherein the film comprises $MP_x$, wherein x is equal to or greater than 15; and M represents an alkali metal.

3. A process as claimed in claim 2 wherein x is substantially equal to 15 and/or M represents potassium.

4. A process as claimed in any of claims 1 to 3 wherein the substrate is glass, silicon, tantalum, stainless steel or a III-V semiconductor.

5. A process as claimed in claim 4 wherein the substrate is glass which has a metal layer thereon, the film being deposited on the metal layer.

6. A process as claimed in claim 5 wherein the metal is tantalum, nickel, titanium or aluminium.

7. A process as claimed in claim 4 wherein the substrate is a semiconductor substrate which is gallium phosphide, gallium arsenide or indium phosphide.

8. A process as claimed in any of claims 1 to 7 wherein the sputtering is RF sputtering in an argon atmosphere.

9. A process as claimed in any of claims 1 to 8 wherein a metal is incorporated by co-sputtering.

10. A process as claimed in claim 9 wherein the metal has unfilled d or f orbitals.

11. A process as claimed in claim 9 or claim 10 wherein the metal is nickel.

12. A process as claimed in any of claims 9 to 11 wherein from 5 to 15% of nickel is incorporated.

13. A process as claimed in any of claims 1 to 12 comprising:

    (A) providing a target of $MP_{15}$; and
    (B) providing a source of additional phosphorus.

14. A process as claimed in claim 13 wherein the additional source is provided by incorporating elemental phosphorus at the target of $MP_{15}$ and/or by providing pieces of $MP_x$, wherein x is very much greater than 15, at the target of $MP_{15}$ and/or by providing phosphine gas during sputtering.

15. A process as claimed in any of claims 1 to 14 comprising:

    (A.)  providing a target comprising phosphorus, an alkali metal and a metal dopant; and
    (B.)  sputtering a film of $MP_x$ and the metal dopant onto a substrate from the x target.